(19) Europäisches Patentamt
European Patent Office
Office européen des brevets

(11) Publication number : **0 456 243 B1**

# (12) EUROPEAN PATENT SPECIFICATION

(45) Date of publication of patent specification : **16.08.95 Bulletin 95/33**

(51) Int. Cl.$^6$ : **H05K 3/46,** C04B 35/18, B32B 27/06

(21) Application number : **91107548.9**

(22) Date of filing : **08.05.91**

## (54) Composite sheet and a process for producing ceramic circuit board using same.

(30) Priority : **09.05.90 JP 119430/90**
**26.11.90 JP 323625/90**
**28.11.90 JP 332442/90**
**14.03.91 JP 49515/91**

(43) Date of publication of application : **13.11.91 Bulletin 91/46**

(45) Publication of the grant of the patent : **16.08.95 Bulletin 95/33**

(84) Designated Contracting States : **DE FR GB**

(56) References cited : **GB-A- 1 463 569**

(73) Proprietor : **MATSUSHITA ELECTRIC INDUSTRIAL CO., LTD.**
**1006, Oaza Kadoma**
**Kadoma-shi, Osaka-fu, 571 (JP)**

(72) Inventor : **Baba, Yasuyuki**
**2-142, Yagumocho**
**Niihama-shi (JP)**
Inventor : **Shigemi, Jun**
**6403-1, Ohama**
**Saijo-shi (JP)**
Inventor : **Segawa, Shigetoshi**
**3-545, Kitashinmachi**
**Niihama-shi (JP)**

(74) Representative : **Patentanwälte Leinweber & Zimmermann**
**Rosental 7/II Aufg.**
**D-80331 München (DE)**



Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Jouve, 18, rue Saint-Denis, 75001 PARIS

## Description

### BACKGROUND OF THE INVENTION

The present invention relates to a composite sheet comprising a green sheet and a plastic film used in a process for manufacturing a ceramic circuit board used in an electronic device and a process for producing a ceramic circuit board using the composite sheet.

Recently, attention is paid to a ceramic multi-layer circuit board because it has density higher than that of a multi-layer print board. A method of manufacturing a conventional ceramic multi-layer circuit board and in particular the handling of a green sheet will be described below.

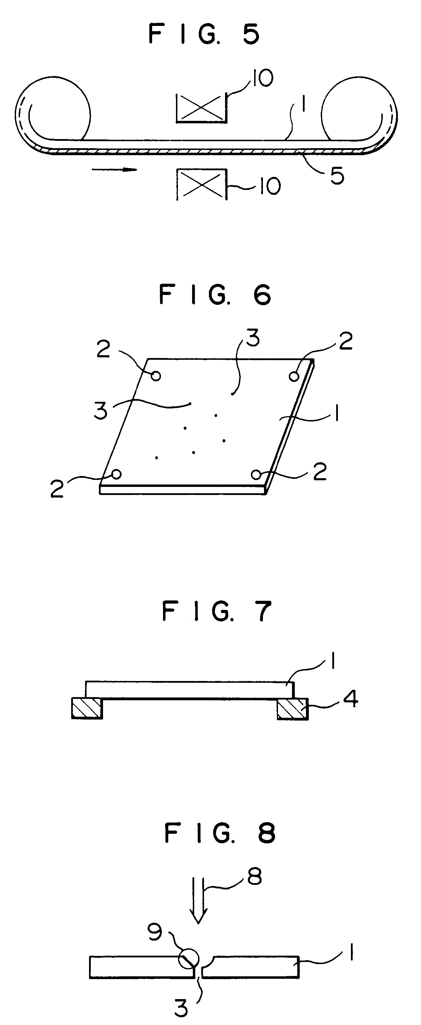

A first prior art method is to handle a green sheet as a single substance, wherein a green sheet is formed on a PET film mainly composed of polyester, the green sheet from which the PET film has been removed is cut to a predetermined size, positioning holes 2 and via holes to provide an electric contact between layers are drilled as shown in Figure 6, the above via holes 3 are filled with a conductive substance, and then a predetermined wiring pattern of a conductive substance is formed on one side 1 of the green sheet. Therefore, a plurality of the green sheets on which the above wiring pattern has been formed are laminated and then calcined.

As shown in Figure 7, a second handling method is to adhere a green sheet 1 to a stainless frame 4 and to handle the green sheet using the corners of the frame 4 as a positioning reference.

Nevertheless, in the above prior art arrangement, the first method has problems in that since the green sheet is soft and liable to break, the handling thereof in each process is difficult, and further since heat is applied to the green sheet in the step of filling the via holes with the conductive substance and the step of drying the conductive substance after the wiring has been printed, the green sheet is greatly shrunk and thus the positioning accuracy thereof is lowered. Further, since a plurality of green sheets on which a wiring pattern has been formed must be laminated when a multi-layer circuit board is made, dimensional accuracy of the green sheet is very important. Although the second method makes the handling of the green sheet easy by the provision of the frame, it has problems in that it is difficult to peel the green sheet adhered to the frame, the frame is curved when it is used for a long time, and the use of the frame makes the employment of a continuous production system impossible, and thus less expensive ceramic circuit boards cannot be provided by mass-production. Further, these methods also have a problem in that an increase in the number of layers in a multi-layer board reduces the thickness of a single green sheet and thus the green sheet is liable to break and bend, even if it is adhered to the frame. Furthermore, they have a problem in that when a laser beam is used in the step of drilling via holes, chipping 9 is formed in the periphery of the via holes 3 of the green sheet 1 to which the laser beam has been irradiated, as shown in Figure 8. Further, they have a problem in that when a prior art ceramic composition is simultaneously calcined with an inner conductive substance, the board is deformed to make the provision of a circuit board of high density impossible.

### SUMMARY OF THE INVENTION

To solve the above prior art problems, an object of the present invention is to provide a composite sheet comprising a green sheet and a plastic film for providing a ceramic circuit board of high quality by greatly improving the handling of the green sheet, and a process for producing a ceramic circuit board using the composite sheet.

To achieve the object, the composite sheet of the present invention comprises a green sheet and a plastic film having a glass transition temperature (hereinafter, referred to as Tg) of 85°C or higher provided on one side of the green sheet.

In the present invention, it is preferable that the plastic film have a thermal shrinkage smaller than that of the green sheet.

With this arrangement, the heat resistant plastic film is provided on the green sheet, and thus when the composite sheet is handled as it is, the plastic film protects the green sheet which is liable to break and extend, any extra jig such as a frame is not necessary, the size of the composite sheet is less changed in a heating step in which a conductive substance and the like are dried, and a roll-to-roll process can be employed, with the result that the handling of the green sheet is greatly improved in the process of manufacturing a ceramic circuit board and a less expensive ceramic multi-layer board of high quality can be provided. Further, even if a chipping is formed in the periphery of the via holes of the plastic film by a laser beam irradiated from the plastic film side, no defect is caused to the green sheet because the plastic film is disposed in a subsequent process. Therefore, this arrangement can greatly improve productivity because a laser beam can be used to drill the via holes. Further, since the green sheet for the multi-layer board is very thin, this arrangement is very

effective because it has the effect of protecting the green sheet by the plastic film as well as the effect of improving a laminating accuracy because the size thereof is less changed even in steps in which heat is applied.

BRIEF DESCRIPTION OF THE DRAWINGS

Figure 1 is a cross sectional view of a composite sheet comprising a green sheet and a plastic film according to a first embodiment of the present invention;
Figures 2 to 5 are cross sectional views of the composite sheet in the respective manufacturing processes of a ceramic circuit board using same;
Figure 6 is a perspective view of a green sheet in a process of manufacturing a prior art ceramic circuit board; and
Figure 7 is a cross sectional view of a green sheet in another process of manufacturing a prior art ceramic circuit board.

DETAILED DESCRIPTION OF THE INVENTION

Example 1

An example of the present invention will be described below with reference to the drawings. First, plastic films used in the experiment include:

(1) Trade name Torelina of Toray Industries Inc. mainly composed or polyphenylene sulfide, which is hereinafter referred to as PPS and represented by the following structural formula;

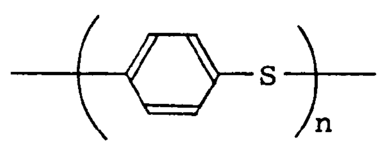

(2) Trade name Superio of Mitsubishi Plastic Industries Ltd. mainly composed of polyether imide, which is hereinafter referred to as PEI and represented by the following structural formula;

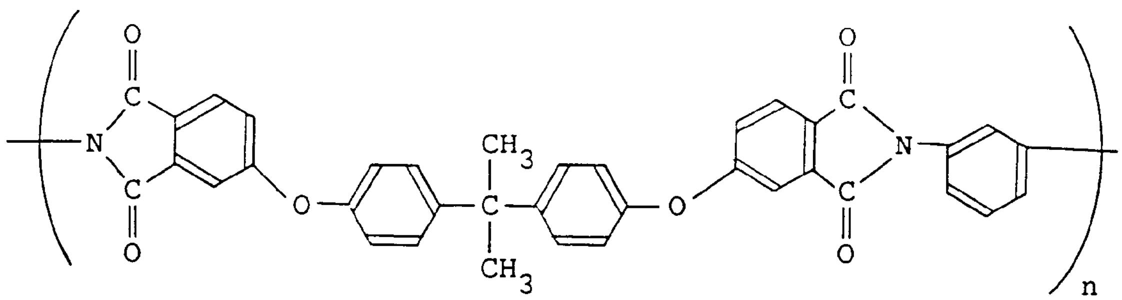

(3) Trade name TALPA-1000 of Mitsui Toatsu Chemicals, Inc. Mainly composed of polyether sulfone, which is hereinafter referred to as PES and represented by the following structural formula;

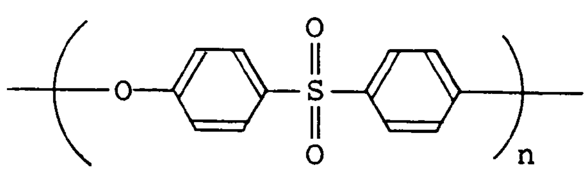

(4) Trade name TALPA-2000 of Mitsui Toatsu Chemicals Inc. mainly composed of polyether ether ketone, which is hereinafter referred to as PEEK and represented by the following structural formula;

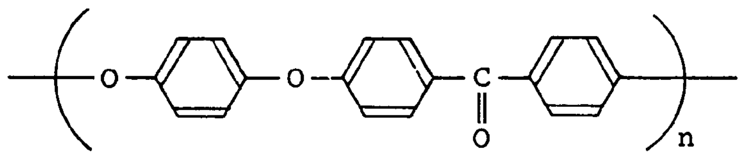

(5) Trade name Kapton of Toray DuPont mainly composed of polyimide, which is hereinafter referred to as PI and represented by the following structural formula;

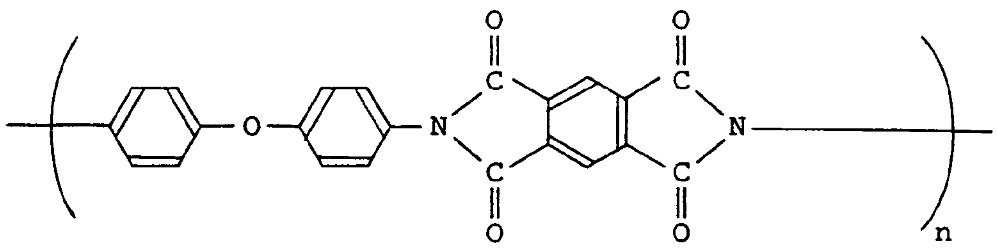

(6) Trade name Lumirror of Toray Industries Inc. mainly composed of polyester, which is hereinafter referred to as PET and represented by the following structural formula;

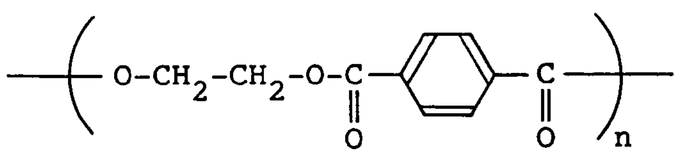

and

(7) a film obtained by subjecting the above PET film to a heat treatment at 100°C or higher to reduce the shrinkage thereof, which is hereinafter referred to as low shrinkage PET and represented by the same chemical formula as the above.

Table 1 shows characteristics of these seven types of the plastic films. In the characteristics shown in Table 1, the breaking strength and the elongation were measured in accordance with JIS-C2318 and the thermal shrinkage shows the largest value measured as to four samples after a heat treatment has been carried out with respect to a forming direction (MD) and a direction (TD) perpendicular to the forming direction in the manufacture of the film with holes having a diameter of 0.15 mm defined at intervals of 100 mm.

Table 1

| Film \ Characteristics | Tg (°C) | Breaking strength ($Kg/mm^2$) | Elongation (%) |
|---|---|---|---|
| PPS | 85 - 95 | 25 | 72 |
| PEI | 211 - 221 | 11 | 100 |
| PES | 218 - 228 | 8.5 | 65 |
| PEEK | 138 - 148 | 9 | 170 |
| PI | 500 < | 18 | 70 |
| PET | 64 - 74 | 27 | 120 |
| Low Shrinkage PET | 64 - 74 | 27 | 120 |

Table 1 (continued)

| Film \ Characteristics | Thermal shrinkage (%) 80°C/30 min | | Thermal shrinkage (%) 100°C/30 min | |
|---|---|---|---|---|
| | MD | TD | MD | TD |
| PPS | 0.017 | 0.017 | 0.011 | 0.017 |
| PEI | 0.030 | 0.026 | 0.020 | 0.024 |
| PES | 0.043 | 0.045 | 0.045 | 0.047 |
| PEEK | 0.023 | 0.010 | 0.008 | 0.021 |
| PI | 0.011 | 0.008 | 0.012 | 0.013 |
| PET | 0.109 | 0.045 | 0.495 | 0.385 |
| Low Shrinkage PET | 0.027 | 0.023 | 0.105 | 0.032 |

As shown in Figure 1, a green sheet was formed on each of these 7 kinds of plastic films 5 having a thickness of 75 micrometers so that the green sheet had a thickness of 200 micrometers or more after drying to make a composite sheet comprising the plastic film 5 and the green sheet 1 necessary to make a ceramic circuit board. Next, via holes having a diameter of 0.15 mm were drilled through the plastic film by numerically controlled punching. At this time, burrs were liable to be formed in the PET film, but the other films had excellent machinability, reason of which is related to the elongation shown in Table 1 and it is easily anticipated that the larger breaking elongation a film had, the more the burrs were liable to be made, which coincided with the result of the experiment. Further, it is anticipated that the smaller the value of the breaking strength shown in Table 1 is, more excellent machinability can be obtained and the life of a pin is made longer when the ceramic circuit boards are made in a mass production. The PEEK film cased a smaller number of burrs as compared with that of the PET film and thus could be practically used. This is because that it had a smaller breaking strength although it had a larger elongation. It is found that in general engineering plastic having a higher heat resistance has a smaller elongation and breaking strength and thus is excellent in stamping machinability. Next, as shown in Figure 2, the via holes 6 were filled with a via conductive substance 7a, the conductive substance 7a was dried at 90°C for 10 minutes, a conductive wiring pattern 7b of a conductive substance was formed on the surface of the green sheet 1, and then it was further dried at 90°C for 10 minutes. Then, the green sheet 1 was removed from the plastic film 5, a plurality of the green sheets on which the wiring pattern was formed were laminated and calcined to provide a multi-layer board. When the reliability of the via contact was confirmed, only the via contact made by using the PET film had defective conductivity, which was found to be caused by the dislocation of the via, when the cross section of the multi-layer board was observed using a SEM to find the reason of the defective conductivity. This dislocation is considered to be caused by that the PET film greatly shrunk in the drying step carried out after the via holes had been filled and the wiring had been printed.

In general, a multi-layer board has an outside dimension of 100 x 100 mm and the diameter of the via hole is expected to be 0.1 mm typically hereinafter. In this case, the dislocation of the via hole caused when the green sheets are laminated must be 50 micrometers or less from the view point of reliability. More specifically, since the green sheets are heated to about 90°C to dry the conductive substance, the thermal shrinkage at 100°C in Table 1 must be 0.05% or less taking a safety factor into consideration. Here, 0.05% of 100 mm is 50 micrometers. According to this experiment, the green sheets which were liable to extend and break could be more easily handled due to the provision of the plastic film as compared with the conventional handling methods described above. Further, when the green sheet is used as a single substance in the process of drying the conductive substance, it shrinks at a ratio of 1% or more, whereas in the case of the composite sheet comprising the green sheet and the plastic film, a less change was caused to the dimension of the green sheet as shown in the thermal shrinkage of Table 1, and thus a ceramic circuit board of high density having excellent dimensional stability and a reliable via contact could be provided. Further, since Tg is a physical value representing a degree of heat resistance, a higher Tg provides a smaller value of the thermal shrinkage except some errors, and it is apparent from Table 1 that a heat resistant film having a Tg of 85°C or higher is more effective, which coincides with the result of the experiment. Further, the via hole was filled in the via filling process in such a manner that a metal mask, through which a transparent hole having a diameter a little larger than that of the via hole was drilled, was placed at the position corresponding to the via hole and a conductive paste was filled from the metal mask side by printing, and thus a land corresponding to the transparent hole of the metal mask was necessarily made to the periphery of the via hole. As shown in Figure 3, however, when the via hole 6 was filled with the via conductive substance 7a from the plastic film 5 side, a landless via 11 could be provided because of that even if a via land 12 was produced, it was removed when the plastic film 5 was removed from the green sheet 1, and thus a multi-layer board of greater density could be provided. It was confirmed by the experiment that when an automatic alignment printer, which is expensive but capable of effecting an accurate alignment was used, the size of the transparent hole of the metal mask could be the same as that of the via hole, and thus a landless via structure could be provided even if the via conductive substance was filled from the green sheet side.

Example 2

The same procedure as in Example 1 was repeated, except that a laser beam was used in the step of drilling via holes. As shown in Figure 4, a laser beam 8 was irradiated from the plastic film side 5 of the composite sheet comprising the green sheet 1 and plastic film 5. Although a chipping 9 was formed on the side of the plastic film 5 to which the laser beam was irradiated, it was only on the surface of the plastic film 5 and the green sheet 1 was not injured at all and thus a straight hole having a diameter from 0.1 mm to 0.2 mm could be drilled. Almost no difference was found in the seven types of the films described in Example 1 with respect to the machinability when the hole was drilled by the laser beam.

Further, when multi-layer boards were made in the same manner as in Example 1, the reliability of the via contact thereof was the same as that in Example 1 and no defect was caused due to the use of the laser beam. Since the experiment proved that the laser beam could be used, the holes could be drilled more efficiently and the problem of the life of a numerical control punch and a pin of a metal mold was solved, and thus productivity could be greatly improved.

Example 3

In the same manner as Example 1, a green sheet was formed on the above seven types of plastic films 5 having a thickness of 75 micrometers so that the green sheet had a thickness of 200 micrometers and then wound in a rolled shape.

Next, as shown in Figure 5, the green sheet 1 to which the plastic film 5 is adhered was sequentially moved in the longitudinal direction thereof, via holes were drilled in the green sheet 1 as well as to the plastic film 5 in the moving process by a machine 10 and then the green sheet 1 was sequentially wound. Similarly, after the via holes were filled and a wiring pattern was formed, the green sheet on which the wiring pattern was formed was cut to a predetermined size together with the plastic film, the green sheet was removed from the plastic film, a plurality of the green sheets were laminated and then calcined to provide a multi-layer board. Although the green sheet was wound in the respective steps in this experiment, it is of course possible to carry out these steps continuously by taking the tact of each step into consideration. Since the employment of this method solves the problem of handling the green sheet which is liable to extend and break and makes a continuous production called a roll-to-roll possible and further since the plastic film excellent in heat resistance is used, a multi-layer board having an improved laminating accuracy and excellent via contact reliability can be made. More specifically, since this method enables mass-production and improves yield, a large number of less expensive multi-layers boards can be made and the application of the boards to consumer products is expected to be made possible. Although Examples 1, 2 and 3 are the case in which the multi-layer board is made, the present invention is of course effective to a circuit board obtained by calcining only one green sheet without piling up green sheets.

Example 4

A ceramic substance which well matches with an inner conductive substance was studied to provide a multi-layer board of high density. Requirements to a board material are such that, first, the material can be calcined at 900°C so that it can be simultaneously calcined with conductive materials having a lower electric resistance such as Ag, Cu etc. and resistor and capacitor materials, second, the material has a dielectric constant lower than that of an alumina board used in a prior art hybrid IC (HIC), that is, it has a dielectric constant of 9 or less, and third, the material shows an excellent interlayer insulation when simultaneously calcined with the inner conductive substance of Ag and Cu and has no difference of a shrinkage between the portion having the inner conductive substance and the portion not having the same. The interlayer reliability was evaluated in such a manner that a confronting electrode of 2 x 2 mm was disposed between insulating layers spaced apart by 200 micrometers and the material was left for 1000 hours in a constant temperature and humidity bath at 85°C and 85% RH with a voltage of 100 V imposed on the electrode, and when the material returned to a room temperature had a insulating resistance of $10^{10}$ ohms or more, it was evaluated as ○ and when the material had an insulating resistance less than $10^{10}$ ohms, it was evaluated as X. with respect to the deformation of the board, a board deformation ratio ΔL is defined as follows to quantitatively represent the deformation:

$$\Delta L = (Lc - Ld)/Lc \times 100\ (\%)$$

wherein Lc is the shrinkage of the board where the inner conductive substance is present and Ld is the shrinkage of the board where the inner conductive substance is not present. When ΔL determined as described above is less than 0.5%, the evaluation of ○ is given. Table 2 shows the composition of the board material which substantially satisfies the above conditions.

Table 2

| Element \ Specimen No. | Glass A + Alumina | | | | |
|---|---|---|---|---|---|
| | 1 | 2 | 3 | 4 | 5 |
| $Al_2O_3$ | 40 | 45 | 50 | 55 | 60 |
| $SiO_2$ | 34.2 | 31.35 | 28.5 | 25.65 | 22.8 |
| $B_2O_3$ | 5.1 | 4.67 | 4.25 | 3.825 | 3.4 |
| $Na_2O$ | 0.9 | 0.825 | 0.75 | 0.675 | 0.6 |
| $K_2O$ | 0.9 | 0.825 | 0.75 | 0.675 | 0.6 |
| CaO | 3.6 | 3.3 | 3.0 | 2.7 | 2.4 |
| MgO | 3.3 | 3.03 | 3.75 | 2.475 | 2.2 |
| PbO | 12 | 11 | 10 | 9 | 8 |
| Total | 100 | 100 | 100 | 100 | 100 |

Table 2 (continued)

| Element \ Specimen No. | Glass B + Alumina | | | | |
|---|---|---|---|---|---|
| | 6 | 7 | 8 | 9 | 10 |
| $Al_2O_3$ | 45 | 50 | 55 | 60 | 65 |
| $SiO_2$ | 33 | 30 | 27 | 24 | 21 |
| $B_2O_3$ | 3.19 | 2.9 | 2.61 | 2.32 | 2.03 |
| $Na_2O$ | 1.925 | 1.75 | 1.575 | 1.4 | 1.225 |
| $K_2O$ | 1.43 | 1.30 | 1.17 | 1.04 | 0.91 |
| CaO | 4.4 | 4 | 3.6 | 3.2 | 2.8 |
| MgO | 1.155 | 1.05 | 0.945 | 0.84 | 0.735 |
| PbO | 9.9 | 9 | 8.1 | 7.2 | 6.3 |
| Total | 100 | 100 | 100 | 100 | 100 |

Table 2 (continued)

| Element \ Specimen No. | Glass A + Cordierite | | |
|---|---|---|---|
| | 11 | 12 | 13 |
| $Al_2O_3$ | 13.97 | 17.44 | 19.17 |
| $SiO_2$ | 56.52 | 55.68 | 55.25 |
| $B_2O_3$ | 3.48 | 2.9 | 2.61 |
| $Na_2O$ | 2.1 | 1.75 | 1.57 |
| $K_2O$ | 1.56 | 1.3 | 1.17 |
| CaO | 4.8 | 4 | 3.6 |
| MgO | 6.77 | 7.93 | 8.53 |
| PbO | 10.8 | 9 | 8.1 |
| Total | 100 | 100 | 100 |

Table 3 shows the composition of the glass A and glass B shown in Table 2.

Table 3

| Element \ Specimen | Glass | |
|---|---|---|
| | A | B |
| $SiO_2$ | 57 | 60 |
| $B_2O_3$ | 8.5 | 5.8 |
| $Na_2O$ | 1.5 | 3.5 |
| $K_2O$ | 1.5 | 2.6 |
| CaO | 6 | 8 |
| MgO | 5.5 | 2.1 |
| PbO | 20 | 18 |
| Total | 100 | 100 |

First, with respect to the glass, a material batch prepared to have the composition of the glass A and glass B shown in Table 3 was put into a platinum crucible, melted at 1500 to 1600°C for 2 to 3 hours, quickly cooled

in water, and then ground in a ball mill to an average particle diameter of about 1.8 micrometers to provide glass powder. Specimens Nos. 1 to 5 in Table 2 were obtained by changing the mixing ratio by weight of the glass A powder and alumina powder from 60/40 to 40/60, specimens Nos. 6 to 10 were obtained by changing the mixing ratio by weight of the glass B powder and the alumina powder from 55/45 to 35/65, and specimens Nos. 11 to 13 were obtained by changing the mixing ratio by weight of the glass B powder and cordierite powder from 60/40 to 45/55. These ceramic powders were formed into a green sheet using acrylic binder to carry out the above experiment, and the result of which is shown in Table 4.

Table 4

| Specimen No. | Dielectric constant (1 MHz) | Reliability of interlayer | Adaptability with inner conductive substance |
|---|---|---|---|
| 1 | 7.44 | O | O |
| 2 | 7.60 | O | O |
| 3 | 7.75 | O | O |
| 4 | 7.92 | O | O |
| 5 | 8.10 | O | O |
| 6 | 6.26 | O | O |
| 7 | 7.64 | O | O |
| 8 | 7.81 | O | O |
| 9 | 7.99 | O | O |
| 10 | 8.19 | X | O |
| 11 | 6.14 | O | O |
| 12 | 5.96 | O | O |
| 13 | 5.87 | O | O |

Specimen No. 10 had insufficient interlayer reliability, which was considered to result from that the specimen was composed of 35 parts by weight of glass powder and 65 parts by weight of alumina powder as a filler component and thus not sufficiently calcined due to the excessive amount of the filler component. More specifically, it was found that any component total amount of which was 100 wt% could provide a multi-layer board of high density which matched with the inner conductive substance better than a prior art multi-layer board so long as the component was selected from the following composition range of the component of the specimens No. 1 to 13 except the specimen No. 10: $Al_2O_3$; 13.97 to 60 wt%, $SiO_2$; 22.8 to 56.52 wt%, $B_2O_3$; 2.32 to 5.1 wt%, $Na_2O$; 0.6 to 2.1 wt%, $K_2O$; 0.6 to 1.56 wt%, CaO; 2.4 to 4.8 wt%, MgO; 0.84 to 8.53 wt%, and PbO; 7.2 to 12 wt%.

As described above, since the plastic film having a Tg of 85° or higher is provided on one side of the green sheet in the present invention. When the composite sheet is handled as it is, the plastic film protects the green sheet which is liable to break and extend, any extra jig such as a frame is not necessary, the size thereof is less changed in the heating step for drying the conductive substance, and the roll-to-roll method can be employed, and thus the handling of the green sheet in the manufacturing process of the ceramic multi-layer circuit

board can be greatly improved and a less expensive ceramic circuit board of high quality can be provided. Further, even if a chipping is formed in the periphery of the via holes of the plastic film by a laser beam irradiated from the plastic film side, no defect is caused to the green sheet because the plastic film is disposed in a subsequent process. Therefore, this arrangement can greatly improve productivity because a laser beam can be used to drill the via holes. Further, this arrangement is very effective because the very thin green sheet for the multi-layer board is protected by the plastic film, the pilling accuracy of the green sheets can be improved since the size thereof is less changed in a heating step, and the reliability of the via contact is improved.

## Claims

1. A composite sheet which comprises a green sheet and a plastic film provided on the green sheet, the green sheet comprising ceramic components, the plastic film comprising a resin having a glass transition temperature of 85°C or higher.

2. A composite sheet of claim 1, wherein the plastic film has a thermal shrinkage smaller than that of the green sheet.

3. A composite sheet of anyone of claims 1 or 2, wherein the plastic film has a thermal shrinkage of 0.05% or less at 100°C.

4. A composite sheet of anyone of claims 1 to 3, wherein the resin is one selected from the group consisting of polyphenylene sulfide, polyether imide, polyether sulfone, polyether ether ketone, and polyimide.

5. A composite sheet of anyone of claims 1 to 4, wherein the ceramic components are selected within the composition range of: $Al_2O_3$; 13.97 to 60 wt%, $SiO_2$; 22.8 to 56.52 wt%, $B_2O_3$; 2.32 to 5.1 wt%, $Na_2O$; 0.6 to 2.1 wt%, $K_2O$; 0.6 to 1.56 wt%, CaO; 2.4 to 4.8 wt%, MgO; 0.84 to 8.53 wt%, and PbO; 7.2 to 12 wt% so that the total amount of the ceramic components becomes 100 wt%.

6. A process for producing a ceramic circuit board comprising the steps of:
   (a) providing a plastic film comprising a resin having a glass transition temperature of 85°C or higher on a side of a green sheet comprising ceramic components to prepare a composite sheet;
   (b) drilling via holes in the composite sheet;
   (c) filling the via holes with an electrically conductive substance;
   (d) forming a wiring pattern on the other side of the green sheet;
   (e) removing the plastic film from the green sheet;
   (f) laminating the green sheets having the wiring pattern; and
   (g) calcining the laminated sheets.

7. A process of claim 6, wherein the side of the composite sheet where the plastic film is provided is irradiated with a laser beam to drill the via holes in the step (b).

8. A process of anyone of claims 6 or 7, wherein the composite sheet is fed in the form of a long belt and the via holes are drilled in the step (b), and is cut to a certain size before the step (e).

9. A process of anyone of claims 6 to 8, wherein the plastic film has a thermal shrinkage of 0.05% or less at 100°C and the composite sheet is dried at 100°C or less after the step (d).

## Patentansprüche

1. Verbundplatte, welche eine Grünlingplatte und einen auf der Grünlingplatte vorgesehenen Kunststoffilm umfaßt, wobei die Grünlingplatte keramische Komponenten umfaßt und der Kunststoffilm einen Einfrierbereich von 85° C oder höher besitzt.

2. Verbundplatte nach Anspruch 1, worin der Kunststoffilm eine kleinere Wärmeschrumpfung als diejenige der Grünlingplatte besitzt.

3. Verbundplatte nach einem der Ansprüche 1 oder 2, worin Kunststoffilm eine Wärmeschrumpfung von 0,05 % oder weniger bei 100° C besitzt

4. Verbundplatte nach einem der Ansprüche 1 bis 3, worin das Harz ein Harz, ausgewählt aus der aus Polyphenylensulfid, Polyetherimid, Polyethersulfon, Polyetheretherketon und Polyimid bestehenden Gruppe, ist.

5. Verbundplatte nach einem der Ansprüche 1 bis 4, worin die keramischen Komponenten ausgewählt sind innerhalb des Zusammensetzungsbereiches: $Al_2O_3$: 13,97 bis 60 Gew.-%; $SiO_2$ : 22,8 bis 56,52 Gew.-%; $B_2O_3$ : 2,32 bis 5,1 Gew.-%; $Na_2O$ : 0,6 bis 2,1 Gew.-%; $K_2O$ : 0,6 bis 1,56 Gew.-%; CaO : 2,4 bis 4,8 Gew.-%; MgO : 0,84 bis 8,53 Gew.-% und PbO : 7,2 bis 12 Gew.-%, so daß die Gesamtmenge der keramischen Komponenten 100 Gew.-% wird.

6. Verfahren zur Herstellung einer keramischen Leiterplatte, umfassend die Stufen von:
(a) Bereitstellung eines Kunststoffilms, der ein Harz umfaßt, das einen Einfrierbereich von 85° C oder höher aufweist, auf einer Seite einer Grünlingplatte, welche keramische Komponenten umfaßt, zur Herstellung einer Verbundplatte;
(b) Bohren von Durchgangslöchern in die Verbundplatte;
(c) Füllen der Durchgangslöcher mit einer elektrisch leitfähigen Substanz;
(d) Ausbildung eines Leitungsmusters auf der anderen Seite der Grünlingplatte;
(e) Entfernen des Kunststoffilms von der Grünlingplatte;
(f) Laminieren der das Leitungsmuster aufweisenden Grünlingplatten; und
(g) Brennen der laminierten Platten.

7. Verfahren nach Anspruch 6, worin die Seite der Verbundplatte, wo der Kunststoffilm vorgesehen ist, mit einem Laserstrahl zum Bohren der Durchgangslöcher in der Stufe (b) bestrahlt wird.

8. Verfahren nach einen der Ansprüche 6 oder 7, worin die Verbundplatte in Form eines langen Bandes zugeführt wird und die Durchgangslöcher in der Stufe (b) gebohrt werden, und sie auf eine bestimmte Größe vor der Stufe (e) geschnitten wird.

9. Verfahren nach einem der Ansprüche 6 bis 8, worin der Kunststoffilm eine Wärmeschrumpfung von 0,05 % oder weniger bei 100° C besitzt und die Verbundplatte bei 100° C oder darunter nach der Stufe (d) getrocknet wird.

## Revendications

1. Plaque composite qui comprend une plaque à l'état vert et un film de matière plastique appliqué sur la plaque à l'état vert, la plaque à l'état vert comprenant des composants céramiques et le film de matière plastique comprenant une résine ayant une température de transition vitreuse de 85°C ou plus.

2. Plaque composite selon la revendication 1, dans laquelle le film de matière plastique a un retrait à la chaleur inférieur à celui de la plaque à l'état vert.

3. Plaque composite selon la revendication 1 ou 2, dans laquelle le film de matière plastique a un retrait à la chaleur de 0,05% ou moins à 100°C.

4. Plaque composite selon l'une quelconque des revendications 1 à 3, dans laquelle la résine est choisie dans le groupe constitué par le poly(sulfure de phénylène), le polyétherimide, la polyéthersulfone, la polyétheréthercétone et le polyimide.

5. Plaque composite selon l'une quelconque des revendications 1 à 4, dans laquelle les composants céramiques sont choisis dans la plage de composition: $Al_2O_3$: 13,97 à 60% en poids; $SiO_2$: 22,8 à 56,52% en poids; $B_2O_3$: 2,32 à 5,1% en poids; $Na_2O$: 0,6 à 2,1% en poids; $K_2O$: 0,6 à 1,56% en poids; CaO: 2,4 à 4,8% en poids; MgO: 0,84 à 8,53% en poids; et PbO: 7,2 à 12% en poids, la quantité totale des composants céramiques s'élevant à 100% en poids.

6. Procédé de fabrication d'une plaquette de circuits imprimés en céramique, comprenant les étapes consistant:

   (a) à appliquer un film de matière plastique, comprenant une résine ayant une température de transition vitreuse de 85°C ou plus, sur une face d'une plaque à l'état vert comprenant des composants céramiques, pour préparer une plaque composite;
   (b) à percer des trous traversants dans la plaque composite;
   (c) à remplir les trous traversants d'une substance électroconductrice;
   (d) à former un motif de câblage sur l'autre face de la plaque à l'état vert;
   (e) à détacher le film de matière plastique de la plaque à l'état vert;
   (f) à stratifier les plaques à l'état vert portant le motif de câblage; et
   (g) à calciner les plaques stratifiées.

7. Procédé selon la revendication 6, dans lequel la face de la plaque composite où le film de matière plastique est appliqué est irradiée par un faisceau laser pour percer les trous traversants dans l'étape (b).

8. Procédé selon la revendication 6 ou 7, dans lequel la plaaque composite est amenée sous la forme d'une bande longue et les trous traversants sont percés dans l'étape (b), et est découpée à un certain format avant l'étape (e).

9. Procédé selon l'une quelconque des revendications 6 à 8, dans lequel le film de matière plastique a un retrait à la chaleur de 0,05% ou moins à 100°C et la feuille composite est séchée à 100°C ou moins après l'étape (d).

F I G. 1

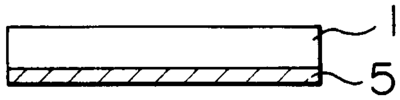


F I G. 2

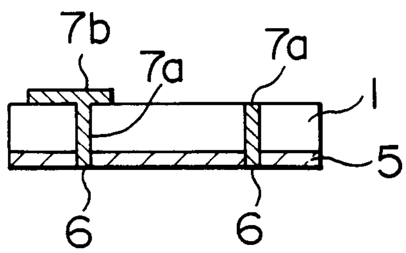


F I G. 3

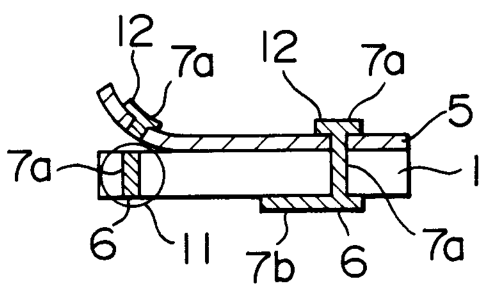


F I G. 4

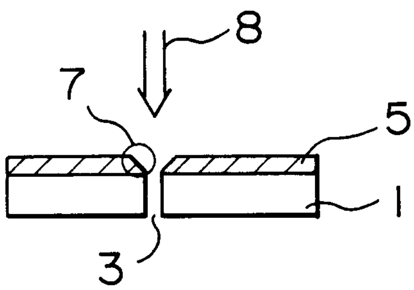

FIG. 5

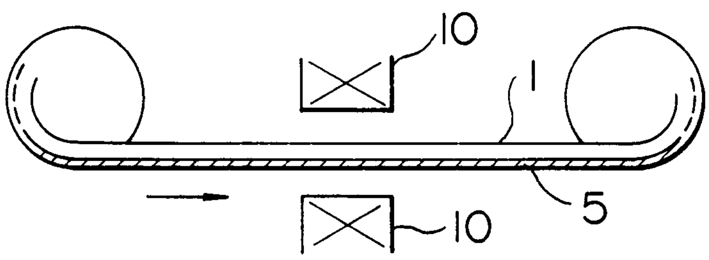


FIG. 6

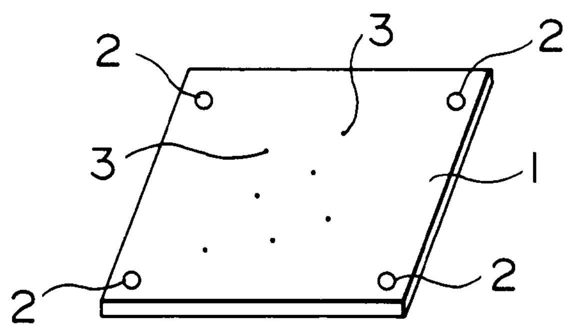


FIG. 7

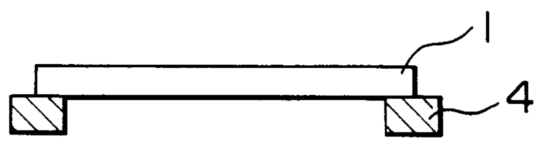


FIG. 8